# FASCICULE DE BREVET EUROPEEN

(11) **EP 2 681 604 B1**
(45) Date de publication et mention de la délivrance du brevet: **17.12.2014**
(21) Numéro de dépôt: 12709931.5
(22) Date de dépôt: 17.02.2012
(51) Int. Cl.: G02B 13/00, G02B 13/14, H04N 5/33, G02B 3/00, G01J 5/08, H04N 5/00

(54) **SYSTEME D'IMAGERIE A HAUTE RESOLUTION**
HOCHAUFLÖSENDES BILDGEBUNGSSYSTEM
HIGH-RESOLUTION IMAGING SYSTEM

(30) Priorité: 04.03.2011 FR 1151790
(43) Date de publication de la demande: 08.01.2014
(73) Titulaire: SAGEM DEFENSE SECURITE, 92100 Boulogne-Billancourt (FR)
(72) Inventeur: CHOMONT, Christian, F-75015 Paris (FR); CAU, Françoise, F-75015 Paris (FR); PEALAT, Michel, F-75015 Paris (FR); DURIAUD, Vincent, F-75015 Paris (FR)
(74) Mandataire: Cabinet Plasseraud
(86) Numéro de dépôt international: PCT/FR2012/050349
(87) Numéro de publication internationale: WO 2012/120214

(56) Documents cités:
- GB-A- 1 057 624
- GB-A- 2 248 310
- US-A1- 2009 122 148

## Description

La présente invention concerne un système d'imagerie à haute résolution. Un système d'imagerie à haute résolution selon l'état de l'art antérieur est par example divulgué dans le document GB-A-2 248310.

De nombreuses applications d'observation nécessitent d'obtenir des images à haute résolution, afin d'identifier des détails de petites dimensions dans une scène qui est observée. Or la résolution d'une image qui est saisie avec un système d'imagerie dépend du grandissement de l'optique de formation d'image qui est utilisée, et de la dimension des éléments photosensibles du capteur d'image.

L'utilisation d'une optique de formation d'image qui possède un grandissement important a pour inconvénient, de façon générale, de réduire le champ d'entrée du système. Autrement dit, les images qui sont formées et saisies sont limitées chacune à une portion restreinte de la scène observée. A l'inverse, l'image de chaque détail de la scène est très petite lorsqu'une optique à large champ d'entrée est utilisée. De plus, lorsque l'image du détail devient plus petite qu'un élément photosensible du capteur d'image qui est utilisé, ce détail n'est plus visible dans l'image saisie.

Cette difficulté d'obtenir des images à haute résolution avec un champ optique d'entrée qui ne soit pas trop petit est encore plus importante pour une observation dans le domaine infrarouge, par rapport à une observation dans le domaine visible. En effet, la dimension individuelle des éléments photosensibles d'un capteur d'image infrarouge est couramment de l'ordre de 12 à 15 µm (micromètre), alors que des capteurs sont disponibles pour le domaine de la lumière visible avec des éléments photosensibles qui ont des dimensions individuelles de l'ordre de 2 à 3 µm. Par exemple, l'acquisition d'une image avec une ouverture angulaire du champ optique d'entrée de 90° (degré) et une résolution angulaire de 200 µrad (microradian) est directement possible en lumière visible avec un capteur de 8000 x 8000 éléments photosensibles. Mais ces caractéristiques d'imagerie ne sont pas réalisables directement pour du rayonnement infrarouge dans la bande de longueur d'onde de 8 à 12 µm.

Les solutions suivantes sont alors utilisées pour palier cette difficulté :
- la mise en oeuvre d'un balayage du champ optique d'entrée du système d'imagerie dans la scène qui est observée. Mais un dispositif mécanique de balayage est alors nécessaire, qui est généralement complexe et fragile ;
- la mise en oeuvre d'un système de zoom pour obtenir la haute résolution dans une partie d'intérêt de la scène observée. Mais le système de zoom nécessite d'utiliser une optique plus complexe et plus onéreuse avec des parties mobiles. En outre, l'utilisation d'un système de zoom a pour inconvénient de réduire considérablement la taille de la scène qui est observée ; et
- l'utilisation de plusieurs capteurs simultanément, qui sont disposés pour saisir respectivement des parties d'image différentes avec une résolution élevée. L'image totale de la scène est ensuite reconstituée en juxtaposant toutes les parties d'image qui sont saisies par les capteurs séparés. Mais un tel système à plusieurs capteurs est particulièrement onéreux, à cause du nombre de capteurs et de la nécessité de les disposer dans des plans d'image différents pour éviter des bandes mortes entre les parties d'images adjacentes qui sont saisies par des capteurs différents.

Dans ces conditions, un but général de la présente invention consiste à fournir un système d'imagerie qui produise des images avec une résolution élevée et un champ optique d'entrée qui ne soit pas trop restreint.

Plus particulièrement, un premier but de l'invention consiste à fournir un système d'imagerie qui produise des images à haute résolution, sans que ce système incorpore de parties mobiles qui soient fragiles ni complexes à réaliser.

Un deuxième but de l'invention consiste à fournir un système d'imagerie qui produise des images à haute résolution permettant de couvrir un champ optique d'entrée qui soit large, par exemple avec une ouverture angulaire de l'ordre de 90°.

Un troisième but de l'invention consiste à fournir un tel système d'imagerie dont le prix n'est pas substantiellement augmenté, notamment un système d'imagerie dont l'optique est simple et qui n'utilise qu'un seul capteur d'image.

Enfin, un objectif général de l'invention est de réaliser les buts précédents pour un système d'imagerie qui est opérationnel dans le domaine infrarouge.

Pour atteindre ces buts et d'autres, l'invention propose un système d'imagerie à haute résolution qui comprend, en suivant un sens de propagation d'un rayonnement utile à l'intérieur du système d'imagerie :
- un objectif, qui est adapté pour former une image intermédiaire d'une scène à l'intérieur d'un plan de focalisation intermédiaire ;
- un filtre d'image, comprenant un masque plan, opaque et muni d'ouvertures qui sont situées dans le plan de focalisation intermédiaire ;
- une matrice plane de microlentilles qui sont identiques et juxtaposées selon au moins deux directions d'alignement, cette matrice de microlentilles étant disposée parallèlement à et à distance du plan de focalisation intermédiaire ;
- une optique de conjugaison, qui est disposée pour former une image de la matrice des microlentilles dans un plan de saisie d'image ; et
- une matrice de détection d'image, qui comprend un ensemble d'éléments photosensibles disposés dans le plan de saisie d'image.

L'objectif, le masque de filtre d'image, les microlentilles, les éléments photosensibles et l'optique de conjugaison sont opérationnels pour le rayonnement utile.

Selon une première caractéristique supplémentaire de l'invention, chaque microlentille et chaque élément photosensible sont conjugués un à un par l'optique de conjugaison.

Selon une deuxième caractéristique supplémentaire de l'invention, les ouvertures du masque de filtre d'image sont en outre disposées en vis-à-vis des microlentilles avec une relation de une pour une entre chaque ouverture et chaque microlentille.

Selon une troisième caractéristique supplémentaire de l'invention, une dimension de chaque ouverture du masque de filtre d'image, lorsqu'elle est mesurée parallèlement à chaque direction d'alignement, est inférieure ou égale à un pas d'échantillonnage de l'image intermédiaire, ce pas d'échantillonnage étant lui-même égal à un pas de répétition des ouvertures du masque de filtre d'image selon la même direction d'alignement, divisé par un facteur d'échantillonnage qui est un nombre entier («integer» en anglais) et supérieur à l'unité.

Selon une quatrième caractéristique supplémentaire de l'invention, le système d'imagerie comprend en outre un dispositif de déplacement d'image qui est adapté pour translater l'image intermédiaire à l'intérieur du plan de focalisation intermédiaire, selon un pas de translation qui est égal à ou multiple du pas d'échantillonnage de l'image intermédiaire parallèlement à chaque direction d'alignement.

Ainsi, dans un système d'imagerie selon l'invention, le plan de saisie d'image dans lequel sont situés les éléments photosensibles de détection et de saisie d'image, n'est pas conjugué optiquement avec l'image intermédiaire de la scène observée qui est formée par l'objectif. A la place de cela, le plan de saisie d'image est conjugué optiquement avec la matrice des microlentilles, celle-ci étant écartée du plan de focalisation intermédiaire d'une distance de séparation déterminée et non nulle. Cette relation de conjugaison optique entre la matrice des microlentilles et le plan de saisie d'image est réalisée par l'optique de conjugaison. Lors d'une utilisation du système d'imagerie, chaque ouverture du filtre d'image constitue alors une pupille pour la microlentille qui est associée avec cette ouverture.

L'image qui est saisie à chaque exposition correspond alors à un échantillonnage de la scène qui est contenue dans le champ optique d'entrée de l'objectif, avec le filtre d'image qui sélectionne une matrice d'échantillonnage dans l'image intermédiaire. Cette sélection est réalisée par le dispositif de déplacement d'image, en plaçant chaque fois l'image intermédiaire dans une position sélectionnée par rapport au filtre d'image. L'échantillonnage de la scène est alors varié lors de saisies d'images successives, pour obtenir des échantillonnages complémentaires de la scène. Autrement dit, le déplacement de l'image intermédiaire par rapport au filtre d'image réalise un balayage de la scène. L'image finale peut alors être reconstruite en combinant les images qui ont ainsi été saisies pour toutes les positions de l'image intermédiaire par rapport au filtre d'image.

La résolution de l'image finale est ainsi multipliée par le facteur d'échantillonnage, par rapport à un système d'imagerie connu avant l'invention, à valeurs identiques du grandissement de l'objectif et de la dimension des éléments photosensibles de la matrice de détection d'image.

Dans divers modes de réalisation de l'invention, la distance entre la matrice de microlentilles et le plan de focalisation intermédiaire est de préférence supérieure à 200 µm.

Un système selon l'invention peut aussi comprendre une unité de contrôle qui est adaptée pour :
- contrôler le dispositif de déplacement d'image de façon à placer l'image intermédiaire successivement dans des positions décalées selon des multiples du pas d'échantillonnage, parallèlement à chaque direction d'alignement ; et
- pour chaque position de l'image intermédiaire, commander une séquence de saisie et d'enregistrement d'image par la matrice de détection d'image.

Il peut encore comprendre une unité de reconstruction d'image, adaptée pour combiner les images qui sont saisies et enregistrées respectivement pour les positions successives de l'image intermédiaire, selon un entrelacement qui est conforme à ces positions successives.

Un système d'imagerie selon l'invention peut être adapté, notamment, pour fonctionner avec un rayonnement utile qui est situé dans le domaine infrarouge.

D'autres particularités et avantages de la présente invention apparaîtront dans la description ci-après d'exemples de réalisation non limitatifs, en référence aux dessins annexés, dans lesquels :
- la figure 1 est un schéma optique de principe d'un système d'imagerie selon la présente invention ;
- la figure 2 est une vue en plan d'une portion d'un filtre d'image qui peut être utilisé dans le système d'imagerie de la figure 1 ;
- les figures 3a et 3b illustrent deux modes de balayage qui peuvent être mis en oeuvre alternativement avec le filtre d'image de la figure 2 ;
- la figure 4 est un schéma optique de principe d'un autre système d'imagerie selon la présente invention, qui est adapté pour un fonctionnement dans le domaine infrarouge ; et
- les figures 5a et 5b illustrent une réalisation concrète d'un système d'imagerie qui est conforme à la figure 4.

Pour raison de clarté, les dimensions des éléments qui sont représentés dans ces figures ne correspondent pas nécessairement à des dimensions réelles ou à des rapports de dimensions réels. En outre, des références identiques qui sont indiquées dans des figures différentes désignent des éléments identiques ou qui ont des fonctions identiques.

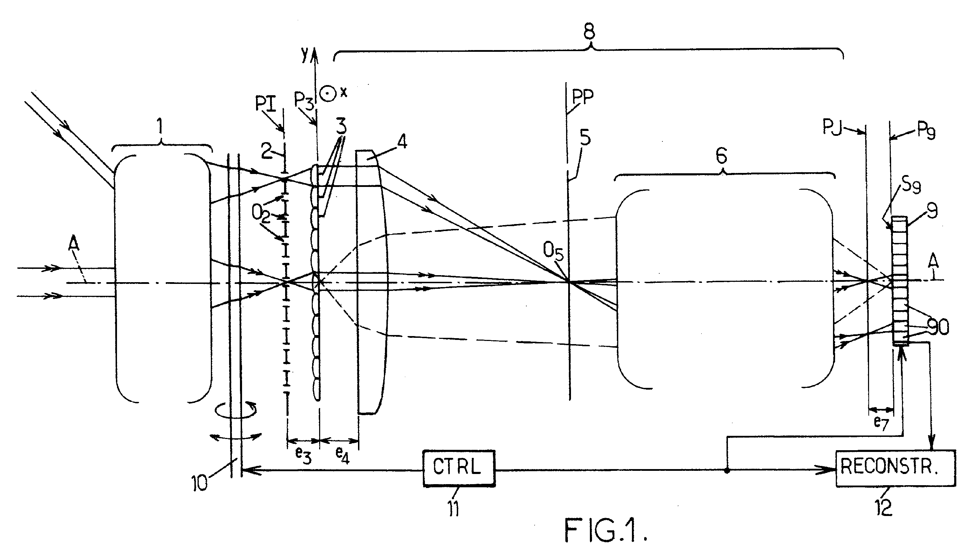

Le principe général de fonctionnement d'un système d'imagerie qui est conforme à l'invention est maintenant décrit dans un premier temps, en référence aux figures 1, 2, 3a et 3b.

Les références qui sont maintenant indiquées désignent les éléments suivants du système d'imagerie :
A-A : axe optique du système d'imagerie,
   1 : objectif disposé selon l'axe optique A-A,
   2 : filtre d'image,
   3 : microlentilles disposées sous forme d'une matrice plane,
   8 : optique de conjugaison,
   9: matrice de détection d'image, appelée couramment capteur d'image,
   90 : éléments photosensibles du capteur d'image 9.

L'objectif 1 est indiqué de façon globale, étant entendu qu'il peut avoir une constitution quelconque, supposée connue de l'Homme du métier. Le modèle de l'objectif 1 peut être sélectionné en fonction du domaine spectral de fonctionnement du système d'imagerie, de son grandissement et de l'ouverture angulaire du champ optique d'entrée, d'une façon qui est appropriée pour chaque application du système. Notamment, l'ouverture du champ optique d'entrée de l'objectif 1 peut être supérieure à 60°, par exemple égale à 90° environ. L'axe optique de l'objectif 1 est superposé avec l'axe A-A du système.

L'objectif 1 forme une image intermédiaire d'une scène qui est située à l'intérieur son champ optique d'entrée, dans un plan de focalisation intermédiaire noté PI. Le plan PI est donc perpendiculaire à l'axe optique A-A.

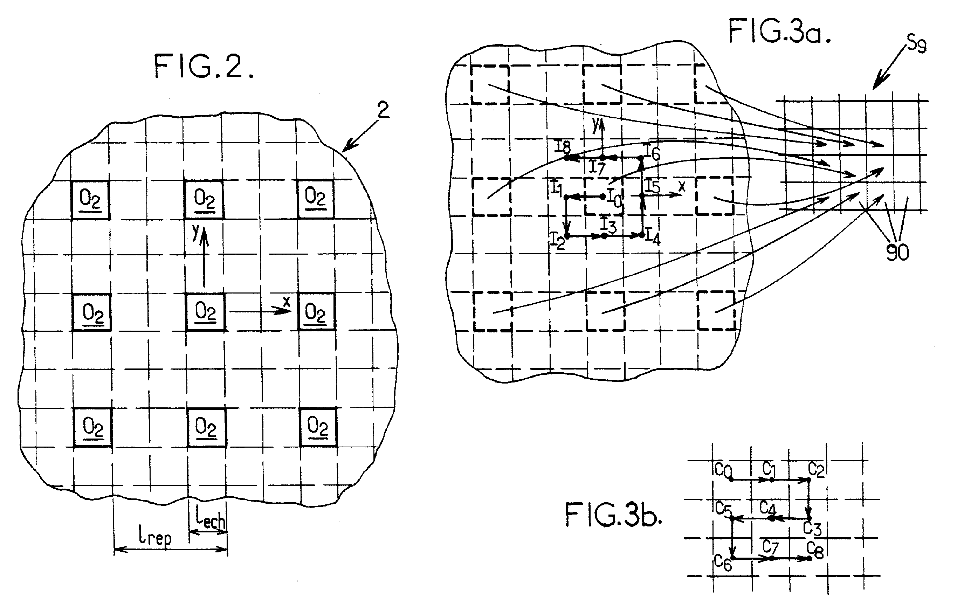

Le filtre d'image 2 peut être un masque plan qui est opaque en dehors d'ouvertures O₂ par lesquelles le rayonnement traverse le masque. Ce masque est constitué d'une feuille très fine, idéalement avec une épaisseur négligeable. Conformément à la figure 2, les ouvertures O₂ sont réparties régulièrement, avec un pas de répétition qui est noté Iᵣₑₚ. Les ouvertures O₂ peuvent être réparties selon deux directions perpendiculaires, avec le pas de répétition Iᵣₑₚ selon chacune de ces directions. Elles forment alors un réseau carré. En outre, chaque ouverture O₂ possède des dimensions qui sont inférieures ou égales à une longueur élémentaire I_{ech} qui est diviseur du pas de répétition Iᵣₑₚ des ouvertures. Pour une raison qui sera expliquée plus loin, la longueur élémentaire I_{ech} est appelée pas d'échantillonnage. A des fins d'illustration, le pas d'échantillonnage I_{ech} qui est représenté sur la figure 2 est égal à un diviseur du pas de répétition Iᵣₑₚ des ouvertures O₂. Le rapport entre les pas Iᵣₑₚ et I_{ech} du filtre d'image est appelé facteur d'échantillonnage («sampling factor») et noté SF. C'est un nombre entier supérieur à l'unité. Dans l'exemple représenté, il est égal à 3.

Le filtre d'image 2 est situé dans le plan de focalisation intermédiaire PI.

La matrice des microlentilles 3 s'étend dans un plan P₃ qui est parallèle au plan de focalisation intermédiaire PI. Le plan P₃ est donc aussi perpendiculaire à l'axe optique A-A. De préférence, les microlentilles 3 sont adjacentes entre elles, de façon à réaliser une partition du plan P₃ sans zones inutiles entre deux microlentilles voisines. Toutes les microlentilles 3 sont identiques entre elles, avec une longueur focale commune f₃. x et y désignent deux directions d'alignement des microlentilles 3 dans le plan P₃.

Le capteur d'image 9 est disposé de sorte qu'une surface de détection de celui-ci, qui est notée S₉, soit située dans un plan de saisie d'image P₉ qui est perpendiculaire à l'axe optique A-A. A l'intérieur de la surface de détection S₉, les éléments photosensibles 90 sont disposés régulièrement, selon un réseau qui dépend du type de capteur utilisé.

La configuration du système d'imagerie possède alors les deux premières caractéristiques suivantes :
/1/l'optique de conjugaison 8 forme une image de la matrice des microlentilles 3 dans le plan de saisie d'image P₉, de sorte que les images respectives de microlentilles 3 qui sont adjacentes sont formées sur des éléments photosensibles 90 qui sont eux-mêmes adjacents dans la surface de détection S₉, sans débordement de l'image de chaque microlentille 3 sur plusieurs éléments photosensibles 90 adjacents ; et
/2/ la répartition des ouvertures O₂ du filtre d'image 2, dans le plan de focalisation intermédiaire PI, reproduit la répartition des microlentilles 3 dans le plan P₃, de sorte que les microlentilles 3 soient associées une à une avec les ouvertures O₂.

Ainsi, la répartition des éléments photosensibles 90 dans la surface de détection S₉ détermine les répartitions des microlentilles 3 et des ouvertures O₂. Les directions x et y sont donc les directions d'alignement communes des ouvertures O₂, des microlentilles 3 et des éléments photosensibles 90, respectivement dans les plans PI, P₃ et P₉. Le pas de répétition Iᵣₑₚ est commun aux ouvertures O₂ et aux microlentilles 3, et est égal au pas des éléments photosensibles 90 dans la surface de détection S₉ du capteur d'image 9, divisé par le grandissement de l'optique de conjugaison 8. Conformément au motif de répartition des ouvertures O₂ qui a été décrit plus haut, celui des éléments photosensibles 90 et celui des microlentilles 3 sont aussi carrés dans la surface de détection S₉ et dans le plan P₃, respectivement.

Dans un mode de réalisation préféré de l'invention, chaque ouverture O₂ du masque de filtre d'image 2 peut être centrée par rapport à la microlentille 3 qui est située en vis-à-vis de cette ouverture.

Dans la figure 1, les rayons qui sont marqués en traits interrompus montrent la relation de conjugaison optique entre les microlentilles 3 et les éléments photosensibles 90, à travers l'optique 8.

Selon une troisième caractéristique /3/ de la configuration du système d'imagerie, le plan P₃ des microlentilles 3 est situé à une distance non nulle du plan de focalisation intermédiaire PI, en aval de ce dernier en suivant le sens de propagation des rayons à l'intérieur du système d'imagerie. La distance non nulle entre les plans PI et P₃ est notée e₃. A cause de cette défocalisation de l'optique de conjugaison 8 par rapport au plan de focalisation intermédiaire PI, ce plan PI est conjugué optiquement par l'optique 8 avec un plan PJ dans lequel se trouve l'image de la scène observée, et qui est distant du plan de saisie d'image P₉. e₇ désigne la distance non nulle de séparation entre les plans PJ et P₉. Dans la figure 1, les rayons marqués en traits continus montrent la relation de conjugaison optique entre le plan de focalisation intermédiaire PI et le plan PJ : les rayons qui sont issus d'un même point d'image intermédiaire contenu dans le plan PI se croisent à l'intérieur du plan PJ, à la distance e₇ de la surface S₈ du capteur d'image 9. Autrement dit, le plan PJ est réellement le plan de formation d'image, qui est distant du plan de saisie d'image P₉.

Selon une possibilité préférée pour la réalisation de l'invention, la distance e₃ entre le plan de focalisation intermédiaire PI et la matrice des microlentilles 3, est égale à la longueur focale f₃ commune des microlentilles 3. Le faisceau des rayons qui proviennent de la scène observée est alors collimaté par les microlentilles 3. Dans ce cas, la distance e₄ entre le plan P₃ des microlentilles 3 et l'optique de conjugaison 8 peut être quelconque.

Selon une réalisation possible de l'optique de conjugaison 8, celle-ci peut comprendre elle-même au moins les éléments suivants, en suivant le sens de propagation du rayonnement utile à l'intérieur du système d'imagerie :
- une optique de refocalisation 4, qui est centrée par rapport à l'axe optique A-A et qui peut être constituée par une lentille convergente de grandes dimensions transversales ;
- un diaphragme 5, qui est situé dans un plan PP conjugué avec le masque de filtre d'image 2 à travers les microlentilles 3 et l'optique de refocal isation 4 ; et
- une optique de relais 6, qui est disposée pour former l'image de la matrice des microlentilles 3 dans le plan de saisie d'image P₉, à travers l'optique de refocalisation 4 et cette optique de relais 6.

Le diaphragme 5 possède une ouverture O₅ qui est centrée sur l'axe optique A-A dans le mode réalisation décrit ici. L'ouverture O₅ peut être de mêmes dimensions que l'image commune de toutes les ouvertures O₂ du masque de filtre d'image 2 à travers la matrice des microlentilles 3 et l'optique de refocalisation 4. Eventuellement, elle peut être plus petite que cette image des ouvertures O₂. Dans ce dernier cas, c'est alors l'ouverture O₅ qui définit la pupille d'entrée de l'ensemble du système d'imagerie, et le plan PP est appelé plan de pupille.

Chaque image qui est ainsi saisie lors d'une séquence d'exposition et de lecture du capteur d'image 9 correspond alors à un échantillonnage de l'image intermédiaire du plan PI. Cet échantillonnage est défini par le filtre d'image 2, avec Iᵣₑₚ qui est la périodicité spatiale de l'échantillonnage de l'image intermédiaire pour chaque séquence d'exposition et de lecture du capteur 9. Simultanément, les dimensions individuelles et la forme des ouvertures O₂ déterminent la fonction de convolution de chaque point de l'échantillonnage.

La figure 3a illustre, par le biais des flèches courbes, l'affectation des ouvertures O₂ du filtre d'image 2, et donc des parties correspondantes de l'image intermédiaire, aux éléments photosensibles 90 du capteur d'image 9. Cette affectation résulte des relations de conjugaison optique qui ont été décrites plus haut.

Le système d'imagerie comprend en outre un dispositif de déplacement de l'image intermédiaire à l'intérieur du plan de focalisation intermédiaire PI. Ce dispositif peut être réalisé de plusieurs façons, qui sont connues de l'Homme du métier. Par exemple, une lame 10, qui est transparente pour le rayonnement utile, peut être disposée entre l'objectif 1 et le plan de focalisation intermédiaire PI. Cette lame 10 possède une inclinaison qui est variable par rapport à l'axe optique de l'objectif 1. Autrement dit, la lame 10 peut être tournée indépendamment et simultanément autour de deux axes perpendiculaires entre eux, qui sont respectivement parallèles aux deux directions d'alignement x et y. De façon connue, une rotation de la lame 10 autour d'un axe parallèle à x provoque un déplacement de l'image intermédiaire parallèlement à y, et vice-versa. En utilisant des incréments adéquats de ces rotations de la lame 10, l'image intermédiaire peut ainsi être translatée d'un nombre entier de fois le pas d'échantillonnage I_{ech} selon les deux directions x et y à l'intérieur du plan PI. En particulier, la lame 10 peut être à faces parallèles.

Selon un mode de réalisation alternatif du dispositif de déplacement de l'image intermédiaire, celui-ci peut comprendre une série de lames transparentes pour le rayonnement utile et interchangeables, chaque lame étant disposée alternativement entre l'objectif 1 et le plan de focalisation intermédiaire PI, et produisant un décalage différent de l'image intermédiaire à l'intérieur de ce plan de focalisation intermédiaire. Par exemple, chacune des lames peut encore être à faces parallèles, avec des inclinaisons qui sont fixes par rapport aux deux directions d'alignement x et y. Deux lames différentes ont alors des épaisseurs et des inclinaisons respectives qui sont adaptées pour translater différemment l'image intermédiaire dans le plan PI, selon des multiples du pas d'échantillonnage I_{ech} parallèlement aux deux directions x et y. Par exemple, de telles lames interchangeables peuvent être montées sur un barillet, qui est agencé pour interposer une seule de ces lames à la fois sur le trajet du rayonnement entre l'objectif 1 et le filtre d'image 2.

A partir d'une première position de l'image intermédiaire dans le plan PI, pour laquelle une première séquence de saisie et d'enregistrement d'image est exécutée par le capteur 9, le dispositif de déplacement de l'image intermédiaire est activé pour amener l'image intermédiaire dans une nouvelle position, distante de la première de nₓ x I_{ech} selon la direction x et de ny x I_{ech} selon la direction y à l'intérieur du plan PI. Pour cela, nₓ et n_{y} sont deux nombres entiers, positifs, négatifs ou nuls. Une nouvelle image est alors saisie et enregistrée par le capteur 9. Cette séquence de déplacement, de saisie et d'enregistrement d'image est encore répétée jusqu'à ce que toutes les positions possibles de l'image intermédiaire par rapport au filtre d'image 2 soient réalisées. Dans l'identification de ces positions possibles de l'image intermédiaire par rapport au filtre d'image 2, deux positions différentes sont séparées de nₓ x I_{ech} selon la direction x et de n_{y} x I_{ech} selon la direction y, nₓ et n_{y} n'étant pas nuls simultanément, et étant limités pour qu'un même point d'image qui est dans l'une des ouvertures O₂ pour l'une des positions de l'image intermédiaire, ne soit pas à l'intérieur d'une autre ouverture dans une autre position de l'image intermédiaire. Les figures 3a et 3b illustrent deux successions possibles de positions de l'image intermédiaire, I₀ à I₈ et C₀ à C₈ lorsque le facteur de échantillonnage SF est égal à 3. A partir de ces exemples, l'Homme du métier saura reproduire l'invention pour une valeur quelconque du facteur d'échantillonnage SF. Par exemple, lorsque le facteur d'échantillonnage SF est égal à 4 ou 5, 16 et 25 positions de l'image intermédiaire par rapport au filtre d'image 2 sont nécessaires, respectivement.

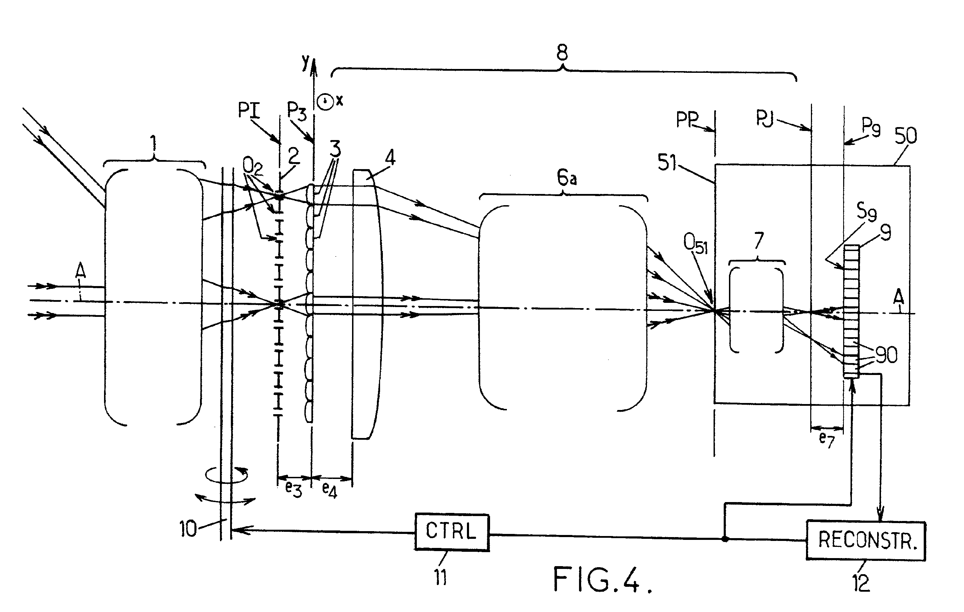

Une unité de commande 11, qui est notée CTRL sur les figures 1 et 4, coordonne les fonctionnements du dispositif de déplacement de l'image intermédiaire et du capteur d'image 9 de la façon qui vient d'être décrite.

Enfin, une unité de reconstruction d'image 12 combine les images qui ont été saisies pour toutes les positions de l'image intermédiaire dans le plan PI, de façon à produire une image finale dont la résolution est I_{ech} dans le plan de focalisation intermédiaire PI. La matrice de cette image finale correspond au pas d'échantillonnage I_{ech}. Pour chaque position l'image intermédiaire dans le plan PI, l'unité 12 affecte alors les valeurs d'intensité qui ont été saisies par le capteur 9 aux pixels de cette matrice d'image, avec une relation d'affectation qui est l'inversé des flèches courbes de la figure 3a. Puis cette étape d'affectation est répétée en reproduisant dans la matrice d'image finale les déplacements successifs de l'image intermédiaire dans le plan PI. L'image finale est ainsi complétée par entrelacement des images qui ont été saisies individuellement pour chaque position de l'image intermédiaire.

Si l'optique de conjugaison 8 n'a pas été ajustée de façon à conjuguer le plan P₃ des microlentilles 3 avec le plan de saisie d'image P₉, une diaphonie intervient entre les pixels de l'image reconstruite, et l'image finale qui est obtenue est floue ou brouillée. Tel est le cas, notamment, lorsque le plan PI du filtre d'image 2 est conjugué optiquement avec le plan P₉.

Selon une autre réalisation possible de l'optique de conjugaison 8 qui est illustrée par la figure 4, l'optique 8 peut comprendre alternativement au moins les éléments suivants, en suivant le sens de propagation du rayonnement utile à l'intérieur du système d'imagerie :
- encore l'optique de refocalisation 4 ;
- une optique de relais 6a, qui est disposée maintenant pour former une image des ouvertures O₂ du masque de filtre d'image 2 à travers les microlentilles 3, l'optique de refocalisation 4 et cette optique de relais 6a ; et
- une partie d'optique finale 7, qui est disposée pour former l'image de la matrice des microlentilles 3 dans le plan de saisie d'image P₉ à travers l'optique de refocalisation 4, l'optique de relais 6a et cette partie d'optique finale 7.

Les autres éléments du système d'imagerie peuvent être identiques dans leur principe de réalisation et de mise en oeuvre à leur description déjà donnée en référence aux figures 1, 2, 3a et 3b.

Comme pour l'objectif 1, des constitutions possibles de l'optique de relais 6a et de la partie d'optique finale 7 sont disponibles pour l'Homme du métier.

Une telle réalisation est particulièrement adaptée pour saisir des images infrarouges. Autrement dit, le rayonnement utile qui est détecté par le capteur d'image 9 peut avoir une longueur d'onde située dans l'une des bandes de 3 à 5 µm (micromètre) et de 8 à 12 µm. L'image commune des ouvertures O₂ du masque de filtre d'image 2 qui est formée à travers les microlentilles 3, l'optique de refocalisation 4 et l'optique de relais 6a constitue une pupille du système d'imagerie. Cette pupille est située dans un plan PP entre l'optique de relais 6a et la partie d'optique finale 7. Un diaphragme 51 peut alors être placé dans le plan PP, pour isoler le capteur d'image 9 par rapport à un rayonnement parasite, notamment d'origine thermique, qui est présent dans le système d'imagerie entre l'objectif 1 et ce diaphragme. Le diaphragme 51 possède une ouverture O₅₁ qui correspond à la pupille du plan PP, celle-ci étant couramment appelée «pupille froide» dans le jargon de l'Homme du métier. En particulier, la partie d'optique finale 7 et le capteur d'image 9 peuvent être contenus dans un cryostat 50, dont une paroi frontale est munie d'une fenêtre d'entrée qui est superposée à l'image des ouvertures O₂ dans le plan de pupille PP, et constitue le diaphragme 51.

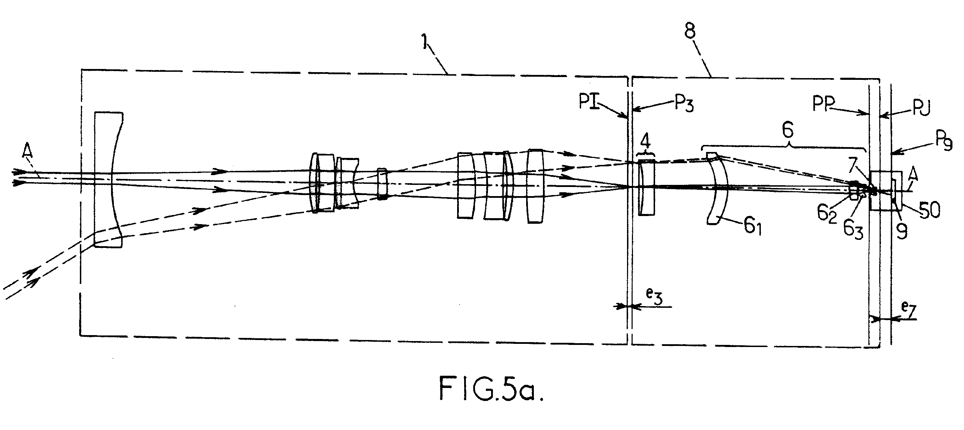

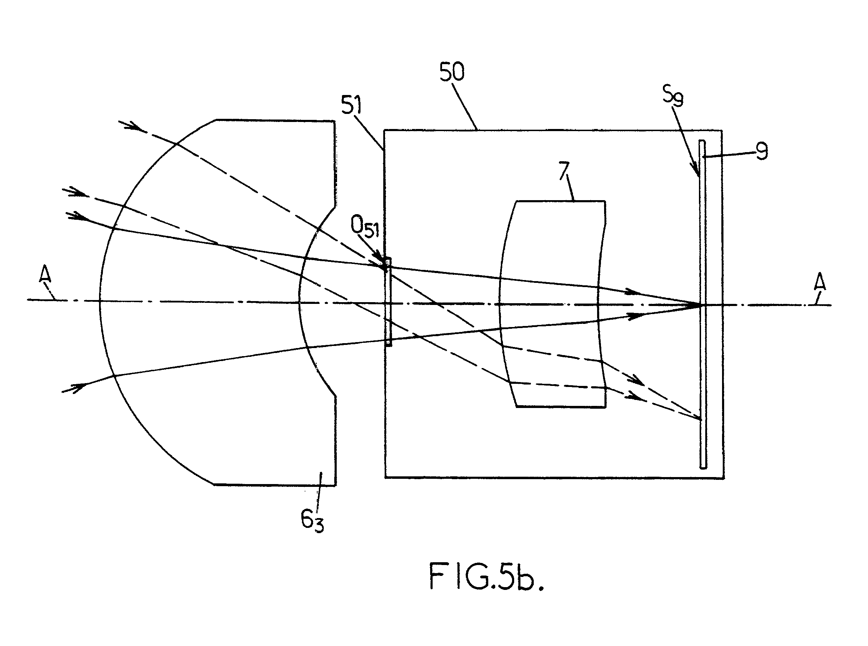

Les figures 5a et 5b représentent une réalisation possible de l'objectif 1 et de l'optique de conjugaison 8 pour un tel dispositif d'imagerie infrarouge. Pour raison de clarté de la figure 5a, le dispositif 10 de déplacement de l'image intermédiaire, le filtre d'image 2 et les microlentilles 3 n'ont pas été représentés, et la figure 5b est une vue grossie de la partie finale du système. Seules sont indiquées les positions du plan de focalisation intermédiaire PI, du plan P₃ des microlentilles 3, du plan de pupille froide PP, du plan de formation d'image PJ et du plan de saisie d'image P₉. L'Homme du métier comprendra par lui-même la signification de chaque élément optique qui est représenté. En particulier, les éléments 6₁ à 6₃ constituent ensemble l'optique de relais 6a. Les valeurs numériques suivantes sont aussi données à titre d'illustration pour un tel système d'imagerie infrarouge conforme à l'invention :
- la matrice des éléments photosensibles 90 du capteur d'image 9 peut avoir un pas de 25 µm, et comporter 400 x 400 éléments photosensibles, avec chaque élément photosensible 90 qui est à base de semiconducteur InGaAs ;
- la lame transparente 10 peut être en béryllium, avec une amplitude d'inclinaison qui est inférieure à quelques degrés ;
- la dimension des ouvertures O₂ du masque de filtre d'image 2 peut être égale au pas d'échantillonnage I_{ech}, de 15 µm ;
- chaque microlentille 3 peut avoir individuellement un diamètre de 100 µm ;
- la distance e₃ entre les plans PI et P₃ peut être de l'ordre de 400 µm ;
- l'ouverture optique du système peut être de F/4 ; et
- le diamètre de l'ouverture de pupille froide O₅₁ peut être de l'ordre de 400 à 500 µm.

Il est entendu que l'invention peut être reproduite en introduisant de nombreuses adaptations par rapport aux modes de réalisation qui viennent d'être décrits en détail, tout en conservant certains au moins des avantages qui ont été cités. Ces adaptations peuvent dépendre de l'application du système d'imagerie. Elles peuvent porter notamment sur la réalisation de l'objectif 1, celle du système de déplacement de l'image intermédiaire ainsi que sur la composition de l'optique de conjugaison 8. De plus, le motif de réseau qui est commun aux ouvertures du masque de filtre d'image, aux microlentilles et aux éléments photosensibles dans leurs plans respectifs peut ne pas être carré, mais rectangulaire, triangulaire, hexagonal, etc.

## Revendications

1. Système d'imagerie à haute résolution comprenant, en suivant un sens de propagation d'un rayonnement utile à l'intérieur dudit système d'imagerie :
- un objectif (1) adapté pour former une image intermédiaire d'une scène à l'intérieur d'un plan de focalisation intermédiaire (PI) ;
- un filtre d'image (2), comprenant un masque plan, opaque et muni d'ouvertures (O₂) situées dans le plan de focalisation intermédiaire (PI) ;
- une matrice plane de microlentilles (3) identiques et juxtaposées selon au moins deux directions d'alignement (x, y), ladite matrice de microlentilles étant disposée parallèlement à et à distance du plan de focalisation intermédiaire (PI) ;
- une optique de conjugaison (8), disposée pour former une image de la matrice des microlentilles (3) dans un plan de saisie d'image (P₉) ; et
- une matrice de détection d'image (9), comprenant un ensemble d'éléments photosensibles (90) disposés dans le plan de saisie d'image (P₉) ;
l'objectif (1), le masque de filtre d'image (2), les microlentilles (3), les éléments photosensibles (90) et l'optique de conjugaison (8) étant opérationnels pour le rayonnement utile,
chaque microlentille et chaque élément photosensible (90) étant conjugués un à un par l'optique de conjugaison (8),
les ouvertures (O₂) du masque de filtre d'image (2) étant en outre disposées en vis-à-vis des microlentilles (3) avec une relation de une pour une entre chaque ouverture et chaque microlentille,
une dimension de chaque ouverture (O₂) du masque de filtre d'image (2), mesurée parallèlement à chaque direction d'alignement (x, y), étant inférieure ou égale à un pas d'échantillonnage (I_{ech}) de l'image intermédiaire, ledit pas d'échantillonnage étant lui-même égal à un pas de répétition (Iᵣₑₚ) des dites ouvertures selon ladite direction d'alignement, divisé par un facteur de sous-échantillonnage entier et supérieur à l'unité,
le système d'imagerie comprenant en outre :
- un dispositif de déplacement d'image adapté pour translater l'image intermédiaire à l'intérieur du plan de focalisation intermédiaire (PI), selon un pas de translation égal à ou multiple du pas d'échantillonnage (I_{ech}) de ladite image intermédiaire parallèlement à chaque direction d'alignement (x, y).

2. Système selon la revendication 1, dans lequel la distance (e₃) entre la matrice de microlentilles (3) et le plan de focalisation intermédiaire (PI) est égale à une longueur focale commune des dites microlentilles.

3. Système selon la revendication 1 ou 2, dans lequel la distance (e₃) entre la matrice de microlentilles (3) et le plan de focalisation intermédiaire (PI) est supérieure à 200 µm.

4. Système selon l'une quelconque des revendications 1 à 3, dans lequel chaque ouverture (O₂) du masque de filtre d'image (2) est centrée par rapport à la microlentille (3) qui est située en vis-à-vis de ladite ouverture.

5. Système selon l'une quelconque des revendications 1 à 4, dans lequel l'optique de conjugaison (8) comprend au moins, en suivant le sens de propagation du rayonnement utile à l'intérieur dudit système d'imagerie :
- une optique de refocalisation (4) ;
- un diaphragme (5) situé dans un plan (PP) conjugué avec le masque de filtre d'image (2) à travers les microlentilles (3) et l'optique de refocal isation (4) ; et
- une optique de relais (6) disposée pour former l'image de la matrice des microlentilles (3) dans le plan de saisie d'image (P₉) à travers l'optique de refocalisation (4) et ladite optique de relais.

6. Système selon l'une quelconque des revendications 1 à 4, dans lequel l'optique de conjugaison (8) comprend au moins, en suivant le sens de propagation du rayonnement utile à l'intérieur dudit système d'imagerie :
- une optique de refocalisation (4) ;
- une optique de relais (6a) disposée pour former une image des ouvertures (O₂) du masque de filtre d'image (2) à travers les microlentilles (3), l'optique de refocalisation (4) et ladite optique de relais ; et
- une partie d'optique finale (7) disposée pour former l'image de la matrice des microlentilles (3) dans le plan de saisie d'image (P₉) à travers l'optique de refocalisation (4), l'optique de relais (6a) et ladite partie d'optique finale.

7. Système selon l'une quelconque des revendications précédentes, adapté pour un rayonnement utile situé dans le domaine infrarouge.

8. Système selon les revendications 6 et 7, comprenant en outre un cryostat (50) contenant la partie finale d'optique (7) et la matrice de détection d'image (9), ledit cryostat étant limité par une paroi munie d'une fenêtre superposée à l'image des ouvertures (O₂) du masque de filtre d'image (2) à travers les microlentilles (3), l'optique de refocalisation (4) et l'optique de relais (6a).

9. Système selon l'une quelconque des revendications précédentes, comprenant en outre une unité de contrôle (11) adaptée pour :
- contrôler le dispositif de déplacement d'image de façon à placer l'image intermédiaire successivement dans des positions décalées selon des multiples du pas d'échantillonnage (I_{ech}), parallèlement à chaque direction d'alignement (x, y) ; et
- pour chaque position de l'image intermédiaire, commander une séquence de saisie et d'enregistrement d'image par la matrice de détection d'image (9).

10. Système selon la revendication 9, comprenant en outre :
- une unité de reconstruction d'image (12), adaptée pour combiner les images saisies et enregistrées respectivement pour les positions successives de l'image intermédiaire, selon un entrelacement conforme aux dites positions successives de l'image intermédiaire.

11. Système selon l'une quelconque des revendications 1 à 10, dans lequel le dispositif de déplacement d'image comprend une lame (10) transparente pour le rayonnement utile, et disposée entre l'objectif (1) et le plan de focalisation intermédiaire (PI), ladite lame ayant une inclinaison variable par rapport à un axe optique de l'objectif (1).

12. Système selon l'une quelconque des revendications 1 à 10, dans lequel le dispositif de déplacement d'image comprend une série de lames transparentes pour le rayonnement utile et interchangeables, chaque lame étant disposée alternativement entre l'objectif (1) et le plan de focalisation intermédiaire (PI), et produisant un décalage différent de l'image intermédiaire à l'intérieur dudit plan de focalisation intermédiaire.

## Patentansprüche

1. Bildgebungssystem mit hoher Auflösung, das entlang einer Ausbreitungsrichtung einer Strahlung, die innerhalb des Bildgebungssystems nutzbar ist, umfasst:
- ein Objektiv (1), das ausgebildet ist, um ein Zwischenbild einer Szene innerhalb einer intermediären Fokussierebene (PI) zu bilden;
- einen Bildfilter (2), der eine ebene, opake Maske umfasst, die mit Öffnungen (O₂) versehen ist, die in der intermediären Fokussierebene (PI) angeordnet sind;
- eine ebene Matrix von Mikrolinsen (3), die identisch und entlang mindestens zwei Ausrichtungsrichtungen (x, y) nebeneinander gereiht sind, wobei die Matrix von Mikrolinsen parallel und beabstandet zu der intermediären Fokussierebene (PI) angeordnet ist;
- eine Konjugationsoptik (8), die angeordnet ist, um ein Bild der Matrix von Mikrolinsen (3) in einer Bilderfassungsebene (P₉) zu bilden; und
- eine Bilddetektionsmatrix (9), die eine Einheit von fotosensiblen Elementen (90) umfasst, die in der Bilderfassungsebene (P₉) angeordnet sind;
wobei das Objektiv (1), die Maske des Bildfilters (2), die Mikrolinsen (3), die fotosensiblen Elemente (90) und die Konjugationsoptik (8) für die nutzbare Strahlung funktionsfähig sind,
wobei jede Mikrolinse und jedes fotosensible Element (90) mittels der Konjugationsoptik (8) 1 : 1 konjugiert werden,
wobei die Öffnungen (O₂) der Maske des Bildfilters (2) außerdem gegenüber den Mikrolinsen (3) in einem Verhältnis 1 : 1 für jede Öffnung und jede Mikrolinse angeordnet sind,
wobei eine Dimension jeder Öffnung (O₂) der Maske des Bildfilters (2), die parallel zu jeder Ausrichtungsrichtung (x, y) gemessen wird, kleiner oder gleich einem Abtastschritt (I_{ech}) des Zwischenbildes ist, wobei der Abtastschritt selbst gleich einem Wiederholungsschritt (Iᵣₑₚ) der Öffnungen entlang der Ausrichtungsrichtung geteilt durch einen Unterabtastfaktor, der ganzzahlig und größer als die Einheit ist, ist
wobei das Bildgebungssystem ferner umfasst:
- eine Vorrichtung zum Verrücken des Bildes, die ausgebildet ist, um das Zwischenbild innerhalb der intermediären Fokussierebene (PI) parallel zu jeder Ausrichtungsrichtung (x, y) gemäß eines Translationsschrittes zu verschieben, der gleich einem oder einer Vielzahl von Abtastschritten (I_{ech}) des Zwischenbildes ist.

2. System nach Anspruch 1, **dadurch gekennzeichnet, dass** der Abstand (e₃) zwischen der Matrix von Mikrolinsen (3) und der intermediären Fokussierebene (PI) gleich einer gemeinsamen Brennweite der Mikrolinsen ist.

3. System nach Anspruch 1 oder 2, **dadurch gekennzeichnet, dass** der Abstand (e₃) zwischen der Matrix von Mikrolinsen (3) und der intermediären Fokussierebene (PI) größer als 200 µm ist.

4. System nach einem beliebigen der Ansprüche 1 bis 3, **dadurch gekennzeichnet, dass** jede Öffnung (O₂) der Maske des Bildfilters (2) bezüglich der Mikrolinse (3) zentriert ist, die gegenüber der Öffnung angeordnet ist.

5. System nach einem beliebigen der Ansprüche 1 bis 4, **dadurch gekennzeichnet, dass** die Konjugationsoptik (8) entlang der Ausbreitungsrichtung der innerhalb des Bildgebungssystems nutzbaren Strahlung mindestens umfasst:
- eine Refokussieroptik (4);
- ein Diaphragma (5), das in einer Ebene (PP) angeordnet ist, die mit der Maske des Bildfilters (2) durch die Mikrolinsen (3) und die Refokussieroptik (4) konjugiert ist; und
- eine Relaisoptik (6), die angeordnet ist, um das Bild der Matrix von Mikrolinsen (3) in der Bilderfassungsebene (P₉) durch die Refokussieroptik (4) und die Relaisoptik zu bilden.

6. System nach einem beliebigen der Ansprüche 1 bis 4, **dadurch gekennzeichnet, dass** die Konjugationsoptik (8) entlang der Ausbreitungsrichtung der innerhalb des Bildgebungssystems nutzbaren Strahlung, mindestens umfasst:
- eine Refokussieroptik (4);
- eine Relaisoptik (6a), die angeordnet ist, um ein Bild der Öffnungen (O₂) der Maske des Bildfilters (2) durch die Mikrolinsen (3), die Refokussieroptik (4) und die Relaisoptik zu bilden; und
- einen Optikendabschnitt (7), der angeordnet ist, um das Bild der Matrix von Mikrolinsen (3) in der Bilderfassungsebene (P₉) durch die Refokussieroptik (4), die Relaisoptik (6a) und den Optikendabschnitt zu bilden.

7. System nach einem beliebigen der vorherigen Ansprüche, **dadurch gekennzeichnet, dass** das System für eine nutzbare Strahlung im Infrarotbereich geeignet ist.

8. System nach den Ansprüchen 6 und 7, ferner umfassend einen Kryostat (50), der den Oprikendabschnitt (7) und die Bilddetektionsmatrix (9) umfasst, wobei der Kryostat von einer Wand begrenzt wird, die mit einem Fenster versehen ist, das mit dem Bild der Öffnungen (O₂) der Maske des Bildfilters durch die Mikrolinsen (3), die Refokussieroptik (4) und die Relaisoptik (6a) überlagert ist.

9. System nach einem beliebigen der vorherigen Ansprüche, ferner umfassend eine Steuereinheit (11), die ausgebildet ist um:
- die Vorrichtung zum Verrücken des Bildes zu kontrollieren, so dass das Zwischenbild sukzessiv in verschobene Positionen gemäß einem Vielfachen des Abtastschrittes (I_{ech}) parallel zu jeder Ausrichtungsrichtung (x, y) verrückt wird; und
- für jede Position des Zwischenbildes eine Sequenz zur Erfassung und Aufnahme des Bildes durch die Bilddetektionsmatrix (9) zu steuern.

10. System nach Anspruch 9, ferner umfassend:
- eine Bildrekonstruktionseinheit (12), die ausgebildet ist, um die erfassten und gespeicherten Bilder jeweils für die sukzessiven Positionen des Zwischenbildes gemäß eines Geflechts, das den sukzessiven Positionen des Zwischenbildes entspricht, zu kombinieren.

11. System nach einem beliebigen der Ansprüche 1 bis 10, **dadurch gekennzeichnet, dass** die Vorrichtung zum Verrücken des Bildes eine für die nutzbare Strahlung transparente Schneide (10) umfasst, die zwischen dem Objektiv (1) und der intermediären Fokussierebene (PI) angeordnet ist, wobei die Schneide bezüglich einer optischen Achse des Objektivs (1) eine variable Neigung hat.

12. System nach einem beliebigen der Ansprüche 1 bis 10, **dadurch gekennzeichnet, dass** die Vorrichtung zum Verrücken des Bildes eine Reihe von für die nutzbare Strahlung transparente und untereinander austauschbare Schneiden umfasst, wobei jede Schneide alternativ zwischen dem Objektiv (1) und der intermediären Fokussierebene (PI) angeordnet ist und eine unterschiedliche Verschiebung des Zwischenbildes innerhalb der intermediären Fokussierebene erzeugt.

## Claims

1. High-resolution imaging system comprising, along a propagation direction of a useful radiation inside the imaging system:
- a lens (1) which is suitable for forming an intermediate image of a scene inside an intermediate focusing plane (PI);
- an image filter (2), comprising an opaque, planar mask, provided with openings (O₂) which are situated in the intermediate focusing plane (PI);
- a planar matrix of microlenses (3) which are identical and juxtaposed in at least two alignment directions (x, y), said matrix of microlenses being arranged parallel to and at a distance from the intermediate focusing plane (PI);
- an optical conjugation system (8), which is arranged in order to form an image of the matrix of microlenses (3) in an image capture plane (P₉); and
- an image detection matrix (9), comprising a set of photosensitive elements (90) arranged in the image capture plane (P₉).
the lens (1), the image filter mask (2), the microlenses (3), the photosensitive elements (90) and the optical conjugation system (8) being effective for the useful radiation,
each microlens and each photosensitive element (90) being conjugated one by one by the optical conjugation system (8),
the openings (O₂) of the image filter mask (2) being moreover arranged facing the microlenses (3) with a one-to-one relationship between each opening and each microlens,
one dimension of each opening (O₂) of the image filter mask (2), measured parallel to each alignment direction (x, y), being less than or equal to a sampling pitch (Iₛₐₘ) of the intermediate image, said sampling pitch being itself equal to a repetition pitch (Iᵣₑₚ) of said openings in said alignment direction, but divided by a sub-sampling factor which is an integer and greater than unity,
the imaging system also comprising:
- an image moving device which is suitable for translating the intermediate image within the intermediate focusing plane (PI), using a translation pitch which is equal to or a multiple of the sampling pitch (Iₛₐₘ) of said intermediate image parallel to each alignment direction (x, y).

2. System according to claim 1, in which the distance (e₃) between the matrix of microlenses (3) and the intermediate focusing plane (PI) is equal to a common focal length of said microlenses.

3. System according to claim 1 or 2, in which the distance (e₃) between the matrix of microlenses (3) and the intermediate focusing plane (PI) is greater than 200 µm.

4. System according to any one of claims 1 to 3, in which each opening (O₂) of the image filter mask (2) is centred with respect to the microlens (3) which is situated facing said opening.

5. System according to any one of claims 1 to 4, in which the optical conjugation system (8) comprises, along the propagation direction of the useful radiation inside said imaging system, at least:
- an optical refocusing system (4);
- a diaphragm (5) situated in a plane (PP) conjugated with the image filter mask (2) through the microlenses (3) and the optical refocusing system (4); and
- an optical relay system (6) arranged in order to form the image of the matrix of microlenses (3) in the image capture plane (P₉) through the optical refocusing system (4) and said optical relay system.

6. System according to any one of claims 1 to 4, in which the optical conjugation system (8) comprises, along the propagation direction of the useful radiation inside said imaging system, at least:
- an optical refocusing system (4);
- an optical relay system (6a) arranged for forming an image of the openings (O₂) of the image filter mask (2) through the microlenses (3), the optical refocusing system (4) and said optical relay system; and
- a optical system end portion (7) arranged for forming the image of the matrix of microlenses (3) in the image capture plane (P₉) through the optical refocusing system (4), the optical relay system (6a) and said optical system end portion.

7. System according to any one of the preceding claims, suitable for a useful radiation situated in the infrared range.

8. System according to claims 6 and 7, also comprising a cryostat (50) containing the optical system end portion (7) and the image detection matrix (9), said cryostat being limited by a wall provided with a window superimposed on the image of the openings (O₂) of the image filter mask (2) through the microlenses (3), the optical refocusing system (4) and the optical relay system (6a).

9. System according to any one of the preceding claims, also comprising a control unit (11) suitable for:
- controlling the image moving device so as to place the intermediate image successively in positions shifted according to multiples of the sampling pitch (Iₛₐₘ), parallel to each alignment direction (x, y); and
- for each position of the intermediate image, issuing a command for an image capture and recording sequence to be performed by the image detection matrix (9).

10. System according to claim 9, also comprising:
- an image reconstruction unit (12), suitable for combining the images which are captured and recorded respectively for the successive positions of the intermediate image, by means of interlacing according to said successive positions.

11. System according to any one of claims 1 to 10, in which the image moving device comprises a plate (10) which is transparent to the useful radiation, and arranged between the lens (1) and the intermediate focusing plane (PI), said plate having a variable inclination with respect to an optical axis of the lens (1).

12. System according to any one of claims 1 to 10, in which the image moving device comprises a series of plates which are transparent to the useful radiation and interchangeable, each plate being arranged alternatively between the lens (1) and the intermediate focusing plane (PI), and producing a different shift of the intermediate image inside said intermediate focusing plane.
